# DEMANDE DE BREVET EUROPEEN

(11) **EP 2 687 919 A1**
(43) Date de publication de la demande: **22.01.2014**
(21) Numéro de dépôt: 12176573.9
(22) Date de dépôt: 16.07.2012
(51) Int. Cl.: G04F 5/06

(54) **Module électronique à résonateur à quartz muni de moyens de fixation antichoc**

(71) Demandeur: ETA SA Manufacture Horlogère Suisse, 2540 Grenchen (CH)
(72) Inventeur: Klopfenstein, François, 2800 Delémont (CH)
(74) Mandataire: Ravenel, Thierry Gérard Louis

(57) **Abrégé**

Le module électronique (1) comprend un résonateur à quartz (3) ou du type MEMS, qui est enfermé dans un boîtier (5) du résonateur, qui est muni de plages de contact électrique (15) sur au moins une surface extérieure pour la connexion électrique du résonateur. Une plaque à circuit imprimé (6) est également prévue pour supporter le boîtier (5) du résonateur et comprend des bornes de connexion électrique (18) pour être reliées aux plages de contact électrique (15) du boîtier du résonateur. Le boîtier (5) du résonateur est maintenu fixement dans une structure de boîtier (6, 9) du module électronique (1) par l'intermédiaire d'au moins un élément amortisseur (7) de chocs mécaniques. L'élément amortisseur (7) peut être un élément en élastomère, qui comprend des fils métalliques (17) pour la connexion électrique du boîtier (5) du résonateur sur la plaque à circuit imprimé (6).

## Description

### DOMAINE TECHNIQUE

La présente invention concerne un module électronique à résonateur à quartz ou du type MEMS, muni de moyens de fixation antichoc. Le résonateur à quartz ou du type MEMS est enfermé dans un boîtier du résonateur, qui est muni de plages de contact électrique sur au moins une surface extérieure pour la connexion électrique du résonateur. Une plaque à circuit imprimé supporte le boîtier du résonateur et comprend des bornes de connexion électrique pour être reliées aux plages de contact électrique du boîtier du résonateur.

### ARRIERE-PLAN TECHNOLOGIQUE

Un résonateur à quartz horloger du type SMD est généralement monté directement sur une plaque à circuit imprimé, afin d'être fixé de manière rigide au mouvement horloger dans la montre. Lorsque la montre est soumise à des chocs mécaniques, le résonateur à quartz dans son boîtier peut être endommagé suite à ces chocs mécaniques transmis directement au résonateur. Ainsi les performances dudit résonateur à quartz peuvent se détériorer et ainsi conduire à une mauvaise précision de fonctionnement. Ce risque est d'autant plus important pour des montres de haute précision, qui bénéficient d'une thermo-compensation. La montre équipée d'un tel résonateur à quartz rigidement fixé au mouvement de montre, est susceptible de perdre de sa précision suite à une simple chute sur un sol dur, ce qui constitue un inconvénient.

La demande de brevet CN 201699667 U décrit un module muni d'un résonateur à quartz du type plug-in. Pour enfermer le résonateur à quartz, le module comprend un couvercle métallique et une base sur laquelle est monté le résonateur à quartz. Le résonateur à quartz est relié électriquement par deux brides conductrices à des tiges sortant du boîtier pour la connexion électrique du module. Ces brides conductrices assurent une certaine élasticité de manière à prévenir le résonateur à quartz de tout choc mécanique du module. Cependant un tel module ne peut être facilement intégré dans une boîte de montre de petite dimension et ne garantit pas une bonne protection du résonateur à quartz lors de chocs mécaniques de la montre, qui comprend ce module électronique, ce qui constitue des inconvénients.

Le brevet CH 609 528 B décrit un module à résonateur à quartz encapsulé dans un boîtier métallique. Un cadre en forme de pont ressort permet de maintenir et relier électriquement le résonateur dans le boîtier pour une connexion électrique vers l'extérieur dudit boîtier. Ce cadre de fixation métallique permet d'assurer une résistance aux chocs mécaniques du résonateur, mais le cadre de fixation est en contact direct mécaniquement et électriquement avec le résonateur à quartz dans le boîtier, ce qui n'assure pas une bonne tenue à des chocs répétés. Cela constitue donc un inconvénient.

### RESUME DE L'INVENTION

L'invention a donc pour but principal de pallier aux inconvénients susmentionnés en proposant un module électronique à résonateur à quartz ou du type MEMS, qui est muni de nouveaux moyens de fixation antichoc, et susceptible de pouvoir être monté dans une montre, telle qu'une montre-bracelet.

A cet effet, la présente invention concerne un module électronique à résonateur à quartz ou du type MEMS, qui comprend les caractéristiques de la revendication indépendante 1.

Des formes d'exécution particulières du module électronique sont définies dans les revendications dépendantes 2 à 14.

Un avantage du module électronique à résonateur à quartz ou du type MEMS selon l'invention réside dans le fait que l'élément amortisseur, qui est de préférence un élément en élastomère, maintient fixement le boîtier contenant le résonateur à quartz ou du type MEMS dans la structure de boîtier du module électronique. Quand le module électronique est monté dans une montre proche du mouvement de montre, tout choc survenant contre la montre se transmet au résonateur dans son boîtier en étant fortement amorti par les moyens de fixation constitués par l'élément en élastomère. Cela protège ledit résonateur de tout choc mécanique et permet de réduire tout risque de perte de précision ou de cassure dudit résonateur.

Avantageusement, deux éléments amortisseurs sont disposés de part et d'autre du boîtier du résonateur pour le maintenir dans la structure de boîtier du module électronique. Ces deux éléments amortisseurs peuvent être des éléments en élastomère, qui peuvent être comprimés entre deux parois intérieures de la structure de boîtier du module électronique. Un des éléments en élastomère peut être disposé entre la plaque à circuit imprimé et le boîtier du résonateur. Cet élément en élastomère peut également comprendre des fils conducteurs pour connecter des bornes de connexion électrique de la plaque à circuit imprimé à des plages de contact électrique du boîtier du résonateur.

### BREVE DESCRIPTION DES FIGURES

Les buts, avantages et caractéristiques du module électronique à résonateur à quartz ou du type MEMS apparaîtront mieux dans la description suivante de manière non limitative en regard des dessins sur lesquels :
- la figure 1 représente une coupe transversale d'un boîtier enfermant un résonateur à quartz pour le module électronique selon l'invention,
- la figure 2 représente une vue schématique partielle d'une première forme d'exécution en coupe partielle du module électronique à résonateur à quartz ou du type MEMS selon l'invention, et
- la figure 3 représente une vue schématique partielle d'une seconde forme d'exécution en coupe partielle du module électronique à résonateur à quartz ou du type MEMS selon l'invention.

### DESCRIPTION DETAILLEE DE L'INVENTION

Dans la description suivante, tous les composants du module électronique à résonateur à quartz ou du type MEMS selon l'invention, qui sont bien connus de l'homme du métier dans ce domaine technique ne sont relatés que de manière simplifiée. La description suivante se base principalement sur la manière de fixer par des moyens de fixation antichoc, le boîtier du résonateur à quartz ou du type MEMS dans une structure de boîtier du module électronique.

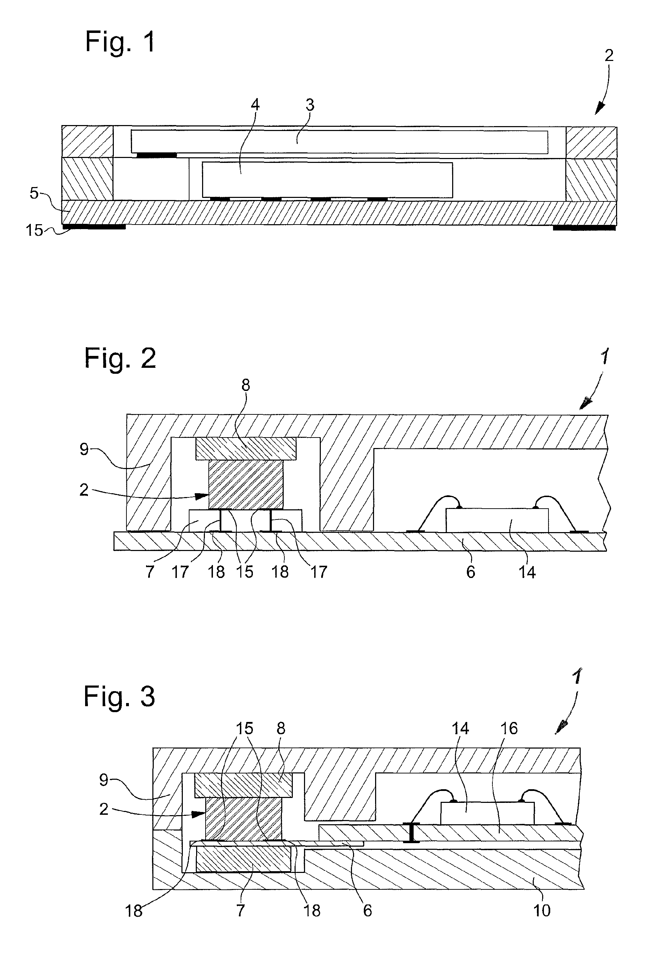

Le composant 2 à résonateur à quartz ou du type MEMS est représenté sommairement sur la figure 1. Ce composant 2 comprend par exemple un résonateur à quartz 3 placé dans un boîtier 5 du résonateur hermétiquement scellé. Ce boîtier du résonateur peut être réalisé dans un matériau métallique ou en céramique. Dans le boîtier du résonateur hermétiquement scellé, il peut également être placé de manière connue un circuit intégré horloger 4 relié audit résonateur à quartz 3. Des plages de contact électrique 15 sont prévues sur au moins une surface extérieure du boîtier 5 du résonateur pour la connexion électrique du résonateur à quartz 3 ou du résonateur avec le circuit intégré horloger 4. Il peut être prévu deux ou quatre plages métalliques de contact électrique disposés aux quatre coins de la surface extérieure rectangulaire du boîtier 5 du résonateur.

Il peut être utilisé pour le module électronique, un composant à résonateur à quartz du type Micro Crystal CM7 ou des types Micro Crystal WM-1322-C7 et WM-1323-C7. Cependant d'autres types de composants à résonateur à quartz ou du type MEMS peuvent aussi être utilisés pour ledit module électronique. Les dimensions d'un tel composant à résonateur à quartz peuvent être de 3 à 4 mm de long, de 1.5 à 2 mm de large et d'une épaisseur inférieure à 1 mm.

La figure 2 représente schématiquement une première forme d'exécution du module électronique 1 à résonateur à quartz ou du type MEMS. Les différents éléments de cette figure 2 sont représentés sans tenir compte de leurs dimensions réelles. Le composant 2 à résonateur à quartz ou du type MEMS est maintenu fixe dans une structure de boîtier du module électronique 1 par l'intermédiaire d'au moins un élément amortisseur 7. Cet élément amortisseur, qui peut être réalisé en élastomère, permet de protéger le résonateur à quartz ou du type MEMS dans le boîtier 5 du résonateur de tout choc mécanique du module électronique. Le composant 2 à résonateur à quartz ou du type MEMS est également monté sur une plaque à circuit imprimé 6. Le composant 2 est de préférence monté sur la plaque à circuit imprimé rigide 6 par l'intermédiaire dudit élément en élastomère 7.

Des bornes de connexion électrique 18 de ladite plaque à circuit imprimé 6, qui comprend aussi un agencement de pistes métalliques non représentées, sont prévues pour être reliées électriquement aux plages de contact électrique 15 du boîtier 5 du résonateur. Le premier élément amortisseur 7, qui est un élément en élastomère, comprend des fils conducteurs 17 dans la matière en élastomère pour relier les plages de contact électrique 15 du boîtier 5 du résonateur aux bornes de connexion électrique 18 de la plaque à circuit imprimé 6. La connexion électrique entre les bornes de connexion 18 et les plages de contact 15 par l'intermédiaire des fils conducteurs 17 peut être réalisée par soudure ou simple contact avec compression de l'élément en élastomère 7.

Le premier élément en élastomère 7 est de type "zebra". De préférence, ce premier élément en élastomère 7 comprend des rangées de filaments métalliques 17 régulièrement espacés et traversant de part en part l'épaisseur dudit premier élément en élastomère. Cet élément en élastomère 7, par exemple en silicone peut être du type GB-Matrix de l'entreprise Shin-Etsu. Il peut être d'une épaisseur comprise entre 0.3 à 2.5 mm et d'une longueur et d'une largeur équivalente à celles du boîtier 5 du résonateur à quartz ou du type MEMS utilisé.

De préférence, le boîtier 5 du résonateur peut être maintenu fixement dans la structure de boîtier du module électronique 1 en étant pris en sandwich entre deux éléments amortisseurs 7, 8, qui peuvent être des éléments en élastomère d'un même type ou d'un type différent. Uniquement le premier élément en élastomère est muni des fils conducteurs 17. Le premier élément en élastomère 7 peut être en contact sur toute la surface inférieure du boîtier 5 du résonateur, alors que le second élément en élastomère 8 peut être en contact sur toute la surface supérieure du boîtier 5 du résonateur. Les éléments en élastomère 7 et 8 peuvent également s'étendre de chaque côté de la surface d'appui du boîtier 5 du résonateur. Lesdits éléments amortisseurs en élastomère maintiennent le boîtier 5 du résonateur en étant comprimé entre deux parois ou surfaces intérieures de la structure de boîtier du module électronique 1. Il peut aussi être prévu de coller les deux éléments en élastomère sur les surfaces inférieure et supérieure du boîtier 5 du résonateur.

Dans cette première forme d'exécution, la structure de boîtier du module électronique 1 comprend une base, qui est constituée par la plaque à circuit imprimé 6. Cette plaque à circuit imprimé est de préférence rigide. La structure de boîtier du module électronique 1 comprend encore un couvercle rigide 9, qui est fixé par collage ou soudure sur la plaque à circuit imprimé pour enfermer dans au moins une première cavité, le boîtier 5 du résonateur. Le couvercle peut être en plastique opaque ou en métal. Ce boîtier 5 du résonateur est maintenu fixement dans cette structure de boîtier du module électronique 1 en sandwich entre les deux éléments en élastomère 7 et 8. Une fois que le couvercle 9 est fixé sur la plaque à circuit imprimé, les deux éléments en élastomère 7 et 8 peuvent maintenir fixement le boîtier 5 du résonateur également par compression entre les surfaces intérieures du couvercle 9 et de la plaque à circuit imprimé 6.

La plaque à circuit imprimé 6 peut également comprendre sur une même surface de connexion électrique, un ou plusieurs autres composants électroniques, tels qu'un circuit intégré 14. Ce circuit intégré 14 peut servir par exemple à la gestion des signaux fournis par le résonateur lié au circuit horloger et à la mémorisation de différentes données. Ce circuit intégré 14 peut se situer dans une seconde cavité du couvercle 9. Il peut être prévu également sans être représenté sur la figure 2, que la plaque à circuit imprimé 6 comprend des bornes de connexion externes, qui sont accessibles en dehors de la structure de boîtier du module électronique 1.

La figure 3 représente schématiquement une seconde forme d'exécution du module électronique 1 à résonateur à quartz ou du type MEMS. Le composant 2 à résonateur à quartz ou du type MEMS est monté directement sur la plaque à circuit imprimé 6, qui est de préférence flexible. Les plages de contact électrique 15 du boîtier 5 du résonateur sont fixées directement par soudure sur les bornes de connexion électrique 18 de la plaque à circuit imprimé flexible 6. Ledit boîtier 5 du résonateur fixé sur la plaque à circuit imprimé 6 est également maintenu fixement dans la structure de boîtier du module électronique 1 par l'intermédiaire d'au moins un élément amortisseur 7.

Ce premier élément amortisseur 7 peut être comme pour la première forme d'exécution, un élément en élastomère. Cependant pour cette seconde forme d'exécution, le premier élément en élastomère ne comprend pas de fils conducteurs pour connecter les plages de contact 15 aux bornes de connexion 18, car le composant 2 à résonateur est directement fixé sur la plaque à circuit imprimé 6. De préférence, le boîtier 5 du résonateur fixé sur la plaque à circuit imprimé flexible 6 est maintenu fixement dans la structure de boîtier du module électronique 1 en sandwich entre deux éléments amortisseurs 7 et 8. Les deux éléments amortisseurs peuvent être des éléments en élastomère.

Le premier élément en élastomère 7 est en contact d'une surface intérieure d'une base rigide 10 de la structure de boîtier, et le second élément en élastomère 8 est en contact d'une surface intérieure d'un couvercle rigide et opaque 9 de la structure de boîtier. Ce couvercle 9 est fixé par collage ou soudure sur la base 10. Lors de la fixation du couvercle 9 sur la base, les deux éléments en élastomère 7 et 8 peuvent être comprimés pour assurer un bon maintien du boîtier 5 du résonateur, logé dans une première cavité du couvercle 9.

La plaque à circuit imprimé flexible 6 peut supporter d'autres composants électroniques disposés dans une seconde cavité du couvercle 9. Un agencement de pistes métalliques non représentées de la plaque à circuit imprimé 6 sont prévues pour relier électriquement lesdits composants électroniques, tels qu'un circuit intégré 14. Cependant il peut être prévu de monter les autres composants électroniques sur une autre plaque à circuit imprimé rigide 16, qui est directement reliée mécaniquement et électriquement à la plaque à circuit imprimé flexible 6. La portion de connexion des deux plaques à circuit imprimé 6, 16 peut être disposée dans un passage de dimension adaptée entre les deux cavités de la structure de boîtier. Ceci permet de restreindre le mouvement de la portion de connexion des deux plaques à circuit imprimé dans la structure de boîtier du module électronique 1.

Il est à noter que les deux plaques à circuit imprimé 6 et 16 peuvent ne former qu'une seule pièce, mais avec une épaisseur bien inférieure pour la partie flexible.

A partir de la description qui vient d'être faite, plusieurs variantes de réalisation du module électronique à résonateur à quartz ou du type MEMS peuvent être conçues par l'homme du métier sans sortir du cadre de l'invention définie par les revendications. Le ou les éléments amortisseurs, tels que des éléments en élastomère peuvent être disposés sur des côtés latéraux du boîtier du résonateur. Le boîtier du résonateur peut être fixé à une plaque à circuit imprimé flexible tout en étant maintenu à la structure de boîtier du module électronique par un élément amortisseur fixé sur une partie latérale du boîtier du résonateur. Il peut également être prévu d'utiliser comme élément amortisseur, une bride ressort métallique ou un autre élément élastique susceptible d'amortir tout choc mécanique dudit module électronique.

## Revendications

1. Module électronique (1) à résonateur à quartz ou du type MEMS, ledit module comprenant :
- le résonateur à quartz (3) ou du type MEMS enfermé dans un boîtier (5) du résonateur, qui est muni de plages de contact électrique (15) sur au moins une surface extérieure du boîtier du résonateur, pour la connexion électrique du résonateur,
- une plaque à circuit imprimé (6) pour supporter le boîtier (5) du résonateur et comprenant des bornes de connexion électrique (18) pour être reliées aux plages de contact électrique (15) du boîtier du résonateur,
**caractérisé en ce que** le boîtier (5) du résonateur est maintenu dans une structure de boîtier (6, 9, 10) du module électronique (1) par l'intermédiaire d'au moins un élément amortisseur (7) de chocs mécaniques.

2. Module électronique (1) selon la revendication 1, **caractérisé en ce que** le boîtier (5) du résonateur est maintenu fixement dans la structure de boîtier du module électronique (1) en sandwich entre deux éléments amortisseurs (7, 8).

3. Module électronique (1) selon l'une des revendications précédentes, **caractérisé en ce que** le ou les éléments amortisseurs sont constitués par un ou des éléments en élastomère (7, 8).

4. Module électronique (1) selon la revendication 3, **caractérisé en ce qu'**un premier élément en élastomère (7) est en contact sur toute une surface inférieure du boîtier (5) du résonateur, et **en ce qu'**un second élément en élastomère (8) est en contact sur toute une surface supérieure du boîtier (5) du résonateur.

5. Module électronique (1) selon l'une des revendications 2 à 4, **caractérisé en ce que** les éléments amortisseurs maintiennent le boîtier (5) du résonateur en étant comprimés entre deux parois intérieures de la structure de boîtier du module électronique (1).

6. Module électronique (1) selon la revendication 1, **caractérisé en ce que** la structure de boîtier du module électronique (1) comprend une base constituée par la plaque à circuit imprimé (6), et un couvercle (9) fixé sur la plaque à circuit imprimé, et **en ce que** le boîtier (5) du résonateur est maintenu fixement dans la structure de boîtier du module électronique (1) en sandwich entre deux éléments amortisseurs (7, 8), avec un premier élément amortisseur (7) en contact d'une surface intérieure de la plaque à circuit imprimé (6) et un second élément amortisseur (8) en contact d'une surface intérieure du couvercle (9).

7. Module électronique (1) selon la revendication 6, **caractérisé en ce que** le premier élément amortisseur (7) est un élément en élastomère, qui comprend des fils conducteurs (17) dans la matière en élastomère pour relier les plages de contact électrique (15) du boîtier (5) du résonateur aux bornes de connexion électrique (18) de la plaque à circuit imprimé (6).

8. Module électronique (1) selon la revendication 7, **caractérisé en ce que** le premier élément en élastomère (7) comprend des rangées de filaments métalliques (17) régulièrement espacés et traversant de part en part l'épaisseur du premier élément en élastomère.

9. Module électronique (1) selon la revendication 1, **caractérisé en ce que** les plages de contact électrique (15) du boîtier du résonateur sont fixées directement sur les bornes de connexion électrique (18) de la plaque à circuit imprimé (6), qui est flexible, et **en ce que** le boîtier (5) du résonateur fixé sur la plaque à circuit imprimé flexible (6) est maintenu fixement dans la structure de boîtier du module électronique (1) en sandwich entre deux éléments amortisseurs (7, 8), dont un premier élément amortisseur (7) est en contact d'une surface intérieure d'une base (10) de la structure de boîtier, et dont un second élément amortisseur (8) est en contact d'une surface intérieure d'un couvercle (9) de la structure de boîtier, qui est fixé sur la base (10).

10. Module électronique (1) selon la revendication 9, **caractérisé en ce que** les deux éléments amortisseurs sont des éléments en élastomère, qui sont comprimés entre la surface intérieure de la base (10) et la surface intérieure du couvercle (9).

11. Module électronique (1) selon la revendication 9, **caractérisé en ce que** la plaque à circuit imprimé flexible (6) est connectée à une autre plaque à circuit imprimé rigide (16) supportant d'autres composants électroniques (14).

12. Module électronique (1) selon la revendication 11, **caractérisé en ce que** la plaque à circuit imprimé flexible (6) et la plaque à circuit imprimé rigide (16) ne forment qu'une seule pièce.

13. Module électronique (1) selon la revendication 2, **caractérisé en ce que** le boîtier (5) du résonateur et les éléments amortisseurs sont disposés dans une première cavité de la structure de boîtier (6, 9, 10) du module électronique (1), et **en ce qu'**un ou plusieurs composants électroniques (14) connectés sur la plaque à circuit imprimé (6, 16) sont disposés dans une seconde cavité de la structure de boîtier du module électronique.

14. Module électronique (1) selon l'une des revendications précédentes, **caractérisé en ce que** le boîtier (5) du résonateur comprend le résonateur à quartz (3) ou du type MEMS, et un circuit intégré horloger (4).
